# EUROPÄISCHE PATENTSCHRIFT

(11) **EP 2 069 810 B1**
(45) Veröffentlichungstag und Bekanntmachung des Hinweises auf die Patenterteilung: **07.09.2016**
(21) Anmeldenummer: 07820862.6
(22) Anmeldetag: 02.10.2007
(51) Int. Cl.: G01R 31/02

(54) **VERFAHREN ZUM TESTEN EINER ELEKTRONIKEINHEIT**
METHOD FOR TESTING AN ELECTRONIC UNIT
PROCÉDÉ POUR TESTER UNE UNITÉ ÉLECTRONIQUE

(30) Priorität: 04.10.2006 DE 102006047262
(43) Veröffentlichungstag der Anmeldung: 17.06.2009
(73) Patentinhaber: Endress+Hauser GmbH+Co. KG, 79689 Maulburg (DE)
(72) Erfinder: FRÜHAUF, Dietmar, 79539 Lörrach (DE); GRITTKE, Udo, 79585 Steinen (DE); HUMPERT, Axel, 77866 Reinau (DE); SCHÄUBLE, Harald, 79737 Herrischried (DE)
(74) Vertreter: Andres, Angelika Maria
(86) Internationale Anmeldenummer: PCT/EP2007/060481
(87) Internationale Veröffentlichungsnummer: WO 2008/040744

(56) Entgegenhaltungen:
- EP-A- 0 299 338
- DE-A1- 3 020 620
- DE-A1- 10 313 264
- US-A- 6 133 952
- US-A1- 2002 121 910

## Beschreibung

Die Erfindung bezieht sich auf ein Verfahren zum Testen einer Elektronikeinheit, insbesondere einer Elektronikeinheit einer Vorrichtung zur Bestimmung und/oder Überwachung einer Prozessgröße, wobei die Elektronikeinheit eine Vielzahl von elektrischen Bauteilen aufweist. Weiterhin bezieht sich die Erfindung auf eine Vorrichtung zur Bestimmung und/oder Überwachung mindestens einer Prozessgröße, mit mindestens einem Sensorelement, und mit mindestens einer Elektronikeinheit, wobei die Elektronikeinheit eine Vielzahl von elektrischen Bauteilen beinhaltet.

In der Prozessautomatisierungstechnik werden vielfach Messgeräte eingesetzt, die zur Erfassung bzw. zur Überwachung von unterschiedlichen Mess- oder Prozessgrößen dienen. Die Messgeräte bestehen dabei üblicherweise aus einem Sensorelement, welches ein Messsignal erzeugt, welches von der Prozessgröße oder einer Änderung der Prozessgröße abhängig ist, und einer Elektronikeinheit. Unter der Elektronikeinheit eines Messgerätes oder einer entsprechenden Vorrichtung zur Bestimmung und/oder Überwachung einer Prozessgröße seien dabei im Folgenden alle die Bestandteile verstanden, welche an der Ansteuerung des Sensorelements und/oder an der Verarbeitung der Messsignale beteiligt sind, d.h. die Elektronikeinheit umfasst sowohl die Ansteuerelektronik, als auch den Messumformer. Als Beispiele sind für die Prozessgrößen zu nennen Füllstand, Viskosität, Dichte, Differenzdruck, Druck, Durchfluss, Massendurchfluss, Temperatur, pH-Wert, Redoxpotential oder Sauerstoffgehalt.

In der Elektronikeinheit befinden sich dabei beispielsweise die für die Signalaufbereitung benötigten Schaltungen, welche meist aus analogen Bauteilen auf einer Leiterkarte bestehen.

Bei der Fertigung einer solchen Elektronikeinheit sind Bestückungsfehler nicht auszuschließen. Wobei es die Möglichkeiten gibt, dass ein falsches Bauteil bei der Bestückung verwendet wurde, dass das Bauteil fehlt, dass das Bauteil in einer falschen Lage eingebaut wurde, dass eine Unterbrechung oder ein Kurzschluss vorliegt oder dass eine kalte Lötstelle erzeugt wurde. Um diese Fehler auszuschließen, werden üblicherweise bei der Fertigung die bestückten Leiterplatten an sog. Prüfpunkten ausgemessen. Je nach der Komplexität der Schaltungen kann dabei eine sehr hohe Anzahl von Prüfpunkten vorgesehen sein. Diese Prüfpunkte haben zum einen den Nachteil, dass sie den auf der Leiterplatte zur Verfügung stehenden Platz verringern und zum anderen ist das Auslesen einer solchen Vielzahl von Testsignalen aufwendig und somit kostenintensiv. Eine weitere Problematik von einer Reihe von Bauteilen besteht darin, dass sie mit der Zeit oder aufgrund extremer Betriebs- und Prozessbedingungen (z.B. Temperatursprünge oder sehr extreme Temperaturen) beschleunigt altern und somit ggf. ausfallen. Aus diesem Grund sind regelmäßige Überprüfungen vorgesehen, welche sich im Sinne der vorausschauenden Instandhaltung (Predictive Maintenance) optimieren lassen.

Eine Aufgabe der Erfindung besteht somit darin, die Kontrolle von Bauteilen zu vereinfachen. Eine weitere Aufgabe besteht darin, ein Messgerät anzugeben, welches über die Möglichkeit der vorausschauenden Instandhaltung für seine Bauteile verfügt.

Die Erfindung löst die Aufgabe mit einem Verfahren zum Testen einer
Elektronikeinheit, wobei die Elektronikeinheit eine Vielzahl von elektrischen Bauteilen aufweist, wobei zumindest ein Teil der elektrischen Bauteile in mindestens eine Gruppe zusammengefasst wird, wobei die Gruppe mit einem Abfragesignal beaufschlagt wird, wobei ein Antwortsignal der Gruppe empfangen wird, und wobei das Antwortsignal ausgewertet wird. Die Gruppe der Bauteile weist dabei zumindest zwei Bauteile auf. In einer weiteren Ausgestaltung handelt es sich zumindest um zwei Gruppen. Vorteilhafterweise befindet sich überdies, in dem Fall, dass es sich nur um zwei Bauteile handelt, kein weiteres Bauteil zwischen diesen beiden Bauteilen, d.h. sie sind direkt miteinander verbunden. Alternativ wird für den Test eine passende Verbindung hergestellt, um die Gruppe passend ausmessen zu können. Die Anzahl der Bauteile hängt von der Art der Gruppenbildung ab. Für den Test wird ein beliebiges Abfragesignal als Stimulus auf die Gruppe bzw. auf die Gruppen, wenn mehrere generiert worden sind, gegeben. Von der Gruppe wird dann ein Antwortsignal empfangen oder gemessen. Hierbei handelt es sich beispielsweise um eine Sprungantwort. Je nach Ausgestaltung der Elektronikeinheit werden mehrere Gruppen gebildet, wobei ggf. einzelne Bauteile zu mehr als einer Gruppe gehören. Dabei wird dann jeweils über die einzelnen Gruppen das Antwortsignal gemessen und passend ausgewertet. Das Verfahren findet dabei Anwendung bei der Fertigung der Elektronikeinheit bzw. des Messgerätes oder beim in der Anwendung befindlichen Gerät als Teil der Überwachung bzw. als Teil des Predictive Maintenance. Das Verfahren hat somit den Vorteil, dass die Wartungsintervalle am Bedarf ausgerichtet werden. Weiterhin lässt sich somit auch die Verfügbarkeit der Prozessanlage erhöhen. Das Testen der Elektronikeinheit erfolgt dabei entweder zeitgleich mit den eigentlichen Aufgaben der Elektronikeinheit oder in besonderen Testphasen. Die Elektronikeinheit ist dabei in einer Ausgestaltung ein Bestandteil eines Messgerätes der Prozess- und Automatisierungstechnik. Die Funktion der Elektronikeinheit ist dann in dieser Ausgestaltung die Durchführung der Messung.

Eine Ausgestaltung des erfindungsgemäßen Verfahrens sieht vor, dass das Antwortsignal mit einem Sollwert verglichen wird. Für die Schaltung bzw. für die spezielle Gruppe wird hierfür ein Sollwert ggf. mit einem Toleranzband hinterlegt. Weicht der gemessene Wert von diesem Sollwert ab, so wird dies beispielsweise als Alarm angezeigt oder aus dem Grad der Abweichung wird eine Aussage über die zukünftige Entwicklung getroffen, d.h. es wird z.B. eine vom Benutzer einstellbare Warnung erzeugt.

Eine Ausgestaltung des erfindungsgemäßen Verfahrens beinhaltet, dass aus dem Vergleich des Antwortsignals mit dem Sollwert eine Voraussage auf das zukünftige Verhalten der Bauteile der Gruppe, von welcher das Antwortsignal empfangen wurde, getätigt wird. In dieser Ausgestaltung wird also ganz konkret der gemessen Wert zur Voraussage über die zu erwartende Entwicklung der Bauteile der jeweiligen Gruppe verwendet. In einer Ausgestaltung wird zu mindestens zwei Zeitpunkten das TestVerfahren durchgeführt und die gemessenen bzw. empfangenen Antwortsignale werden in einem Speicher als Historiendaten hinterlegt. Aus dem zeitlichen Verhalten bzw. aus der zeitlichen Entwicklung wird berechnet, wann ein Austauschen der Gruppe ggf. erforderlich ist oder wann eine detaillierte Untersuchung der Elektronikeinheit bzw. des Messgerätes erforderlich sein wird. Hierfür sind entsprechende Algorithmen und Daten zu hinterlegen. Der Sollwert ergibt sich somit aus einem in einer vorhergehenden Testphase gemessenen Antwortsignal.

Eine Ausgestaltung des erfindungsgemäßen Verfahrens sieht vor, dass aus dem Vergleich des Antwortsignals mit dem Sollwert eine Voraussage über die zu erwartende Lebenszeit der Bauteile der Gruppe, von welcher das Antwortsignal empfangen wurde, ermittelt wird.

Eine Ausgestaltung beinhaltet, dass der Spannungsabfall über die Gruppe gemessen wird, und dass der gemessene Spannungsabfall ausgewertet wird. In dieser Ausgestaltung ist somit das Antwortsignal ein Spannungsabfall. Für dieses spezielle Antwortsignal gelten entsprechend auch die vorgenannten Verfahrensschritte der Auswertung. Der Spannungsabfall wird dabei entweder direkt gemessen oder ein ggf. auftretender Stromfluss wird passend umgewandelt. Die Messung des Spannungsabfalls ist deshalb vorteilhaft, weil so beispielsweise ein Analog-Digital-Wandler verwendet werden kann, um die Messdaten ggf. auch von einem Mikroprozessor auswerten zu lassen.

Die folgenden Ausgestaltungen befassen sich mit der Art der Gruppierung der Bauteile.

Eine Ausgestaltung des erfindungsgemäßen Verfahrens beinhaltet, dass die Gruppe gemäß der Ausfallrate der Bauteile gebildet wird. Für eine Vielzahl von Bauteilen (Widerstände, Kondensatoren, Operationsverstärker, Prozessoren usw.) gibt es Daten bzgl. der Lebensdauer. D.h. ausgehend von einer Schaltung der Elektronikeinheit lassen sich in Verbindung mit den zugehörigen Daten, die beispielsweise in einer Datenbank (als Beispiele zu nennen sind hier Datenbanken von Siemens, British Telecom, Military Handbook MIL-HDBK-217) hinterlegt sind, die Bauteile identifizieren, die eine höhere Ausfallrate aufweisen. Um diese Bauteile herum werden dann die Gruppen gebildet.

Eine Ausgestaltung des erfindungsgemäßen Verfahrens sieht vor, dass die Gruppe gemäß der Funktion der Bauteile in der Elektronikeinheit gebildet wird. Es wird also beispielsweise unterschieden zwischen den Bereichen Vorverstärkung, Signalfilterung, Phasenverschiebung, Signalumsetzung für Buskommunikation usw. Jeder dieser funktionellen Einheiten wird dann in eine eigene Gruppe zugeordnet. Oder umgekehrt: Die Bauteile der einzelnen Gruppen unterscheiden sich in Hinsicht auf ihre funktionellen Aufgaben innerhalb der Elektronikeinheit, ihre Lebensdauern oder ihren Einfluss auf das Antwortsignal als Reaktion der Gruppe auf das Abfragesignal. Insbesondere die funktionelle Gruppierung ist aufgrund des Schaltungsplanes möglich. Die Gruppierungen können dabei in Abhängigkeit, ob das erfindungsgemäße Testverfahren bei der Fertigung oder im Rahmen der vorausschauenden Instandhaltung Anwendung findet, gleich oder unterschiedlich sein. Bei der Fertigung können die Gruppierungen beispielsweise über solche Bauteile erfolgen, bei welchen es zu einer falschen Einbauposition kommen kann (z.B. Dioden).

Eine Ausgestaltung des erfindungsgemäßen Verfahrens beinhaltet, dass mindestens die Messung des Spannungsabfalls mit mindestens einem Analog-Digital-Wandler erfolgt, welcher in Bezug auf die Funktion der Elektronikeinheit ungenutzt ist. Der Analog-Digital-Wandler ist in einer Ausgestaltung ein Bestandteil eines Mikroprozessors, welcher in der Elektronikeinheit angeordnet ist. Ist die Elektronikeinheit beispielsweise ein Bestandteil eines Messgerätes, so besteht die Funktion in der Durchführung der Messung.

Eine Ausgestaltung des erfindungsgemäßen Verfahrens sieht vor, dass die Gruppe derartig modifiziert und/oder erweitert wird, dass eine Änderung mindestens eines Bauteiles der Gruppe zu einer Änderung des von der Gruppe empfangbaren Antwortsignals führt. Die Ausgestaltung besteht somit darin, dass die Gruppe ggf. durch das Hinzunehmen für diesen Zweck vorhandenen zusätzlichen Bauteilen derartig geändert oder erweitert wird, dass beispielsweise ein Alterungsprozess eines Bauteils auch zu einer Änderung des Antwortsignals führt. D.h. die Änderung eines Bauteils oder der Bauteile wird in den Bereich der Messbarkeit durch das Antwortsignal überführt. Diese Ausgestaltung bezieht sich insbesondere auf die Messung des Spannungsabfalls als Antwortsignal.

Die Erfindung löst die Aufgabe weiterhin durch eine Vorrichtung zur Bestimmung und/oder Überwachung mindestens einer Prozessgröße, mit mindestens einem Sensorelement, und mit mindestens einer Elektronikeinheit, wobei die Elektronikeinheit mindestens eine Vielzahl von elektrischen Bauteilen beinhaltet, wobei mindestens eine Steuereinheit vorgesehen ist, welche derartig ausgestaltet ist, dass die Steuereinheit mindestens eine Gruppe mindestens eines Teiles der Bauteile mit einem Abfragesignal beaufschlagt, dass die Steuereinheit von der Gruppe ein Antwortsignal empfängt, und dass die Steuereinheit das Antwortsignal in Hinsicht auf Veränderungen der Bauteile der Gruppe auswertet. Im erfindungsgemäßen Messgerät wird somit aus einem Teil der Bauteile der Elektronikeinheit eine Gruppe gebildet. Vorzugsweise sind mindestens zwei Gruppen gebildet und jede Gruppe besteht zumindest aus zwei Bauteilen. Die Gruppe besteht beispielsweise aus besonders alterungsanfälligen Bauteilen, aus besonders wichtigen Bauteilen oder aus möglichst vielen Bauteilen. Einzelne Varianten zur Gewinnung dieser Gruppen sind oben beim erfindungsgemäßen Verfahren beschrieben und können beim erfindungsgemäßen Messgerät ebenfalls Verwendung finden. Von der Gruppe der Bauteile wird nach einer Beaufschlagung mit einem Abfragesignal ein Antwortsignal gemessen und in Hinsicht auf Alterungserscheinungen oder andere Veränderungen der Bauteile dieser Gruppe auswertet, indem z.B. der gemessene Wert mit hinterlegten Daten verglichen wird. In einer Ausgestaltung ist die Elektronikeinheit derartig ausgestaltet, dass sie das Sensorelement mit einem Anregungssignal beaufschlagt, vom Sensorelement ein Messsignal empfängt und das Messsignal verarbeitet, z.B. in Hinsicht auf die Prozessgröße auswertet. In einer Ausgestaltung handelt es sich bei der Steuereinheit um einen Mikroprozessor, welcher derartig ausgestaltet ist, dass der Mikroprozessor den Spannungsabfall über mindestens eine Gruppe mindestens eines Teiles der Bauteile in Hinsicht auf Veränderungen der Bauteile der Gruppe auswertet. Das Antwortsignal ist also in diesem Fall ein Spannungsabfall.

Eine Ausgestaltung der erfindungsgemäßen Vorrichtung sieht vor, dass mindestens ein Analog-Digital-Wandler vorgesehen ist, welcher frei von den Messaufgaben ist und über welchen die Steuereinheit das Antwortsignal aufnimmt. Handelt es sich bei der Steuereinheit um einen Mikroprozessor, so ist in einer Ausgestaltung der Analog-Digital-Wandler ein Bestandteil des Mikroprozessors. Der Analog-Digital-Wandler ist in dieser Ausgestaltung speziell für das Testverfahren vorgesehen. In einer alternativen Ausgestaltung dient der Analog-Digital-Wandler auch der eigentlichen Messung der Prozessgröße.

Die Erfindung wird anhand der nachfolgenden Zeichnungen näher erläutert. Es zeigt:
Fig. 1: eine schematische Darstellung einer erfindungsgemäßen Vorrichtung, und
Fig. 2: eine schematische Darstellung einer Verwendung eines erfindungsgemäßen Messgerätes in einer Prozessanlage.

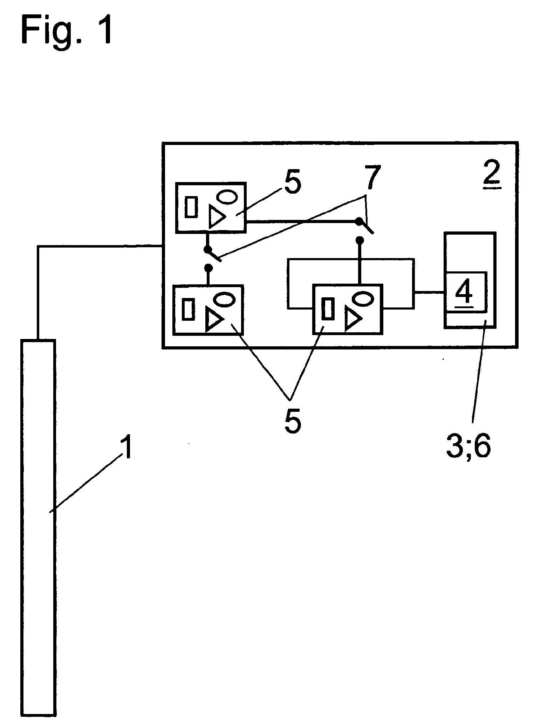

In der Fig. 1 ist schematisch ein kapazitives Messgerät dargestellt. Das Sensorelement 1 ist dabei ein Stab, welcher mit einer elektrischen Wechselspannung als Anregungssignal von der Elektronikeinheit 2 beaufschlagt wird. Das Sensorelement 1 und eine zweite - hier nicht dargestellte - Sonde oder die - hier ebenfalls nicht gezeigte - Wandung eines Behälters bilden mit einem Medium, dessen Füllstand beispielsweise gemessen werden soll, als Dielektrikum einen Kondensator, dessen Kapazität ein Maß für den Füllstand des Mediums ist.

In der Elektronikeinheit 2 befindet sich eine Vielzahl von Bauteilen, deren Eigenschaften (z.B. bei der Fertigung) oder deren Veränderung mit der Zeit es zu testen gilt. Erfindungsgemäß sind die Bauteile zu einzelnen Gruppen 5 zusammengefasst. Die Gruppen 5 beziehen sich dabei auf lokal benachbarte Bauteile oder auf entfernt, z.B. auf einer Platine oder Leiterplatte angebrachte Bauteile, die für die Gruppenbildung und ggf. auch nur für die Testphasen passend elektrisch miteinander zu verbinden sind. Die Gruppen umfassen dabei beispielsweise vorgegebenen Prüfpunkte, welche sensitiv auf die Änderungen einer Vielzahl von Bauteilen sind, oder auf Bauteile, welche besonders alterungsanfällig (deren im Mittel zu erwartender Ausfallszeitpunkt beispielsweise kleiner ist als die ggf. vorgeschriebenen Wartungsintervalle) sind oder auf funktionelle Einheiten innerhalb der Elektronikeinheit oder auf die Kombination von Bauteilen, die so zusammenwirken, dass eine Veränderung der Eigenschaft eines Bauteiles zu einer Änderung des Spannungsabfalls (dies hier als Beispiel für das Antwortsignal) über diese Gruppe 5 führt. Ggf. werden die Gruppen auch durch zusätzliche Bauteile ergänzt, die insbesondere dem Testen dienen und die es erlauben, eine Veränderung eines Bauteils anhand des Spannungsabfalls zu erkennen. Dargestellt sind auch zwei Schalter oder Trennelemente 7, welche für den Test die einzelnen Bauteilegruppen 5 voneinander trennen, so dass die Bauteile gesondert voneinander und abgekoppelt von den für den Messbetrieb erforderlichen Verbindungen getestet werden. D.h. im normalen Messbetrieb sind diese Trennelemente oder Schalter 7 geschlossen. Weiterhin sind in einer weiteren Ausgestaltung innerhalb der Gruppen 5 Schalter vorhanden, welche für das Testen geschlossen werden.

Besonders alterungsanfällige Bauteile sind beispielsweise: Elektrolytkondensatoren (Elkos), Optokoppler, Leistungstransistoren oder Halbleitersensoren. Über diese Gruppen 5 wird jeweils der Spannungsabfall gemessen, welcher über einen Analog-Digital-Wandler 4 vom Mikroprozessor verarbeitet wird. In einer weiteren Ausgestaltung ist der Analog-Digital-Wandler 4 mit einem Multiplexer verbunden, so dass diesem Wandler die Spannungssignale der einzelnen Gruppen zugeführt werden. Hierfür wird ggf. auch ein spezielles Testsignal an die Gruppen 5 angelegt, um ggf. auch spezielle Messungen durchführen zu können. Die Spannungsabfälle über die einzelnen Gruppen 5 werden dann in dem Mikroprozessor 6, bei welchem es sich in diesem Beispiel um die Steuereinheit 3 handelt, passend ausgewertet, indem sie beispielsweise mit Sollwerten oder mit bereits abgespeicherten Spannungsabfällen von vorhergehenden Testmessungen verglichen werden. Tritt beispielsweise eine Abweichung größer als ein vorgebbarer Toleranzbereich auf, so wird beispielsweise eine Warnung oder ein Alarm ausgegeben. Gleichzeitig lässt sich auch bei einem bekannten Verhalten der Gruppe 5 der Bauteile ausgehend von den Messungen bestimmen, wann es mit hoher Wahrscheinlichkeit zu einem Ausfall innerhalb der Bauteile der Gruppen kommen wird. Somit lassen sich auch Wartungsintervalle an den konkreten Fall anpassen und optimal vorgeben. Dabei werden Aussagen stets nur über die gesamte Gruppe 5 getätigt.

Das hier in dem Messgerät umgesetzte Verfahren besteht somit aus folgenden Schritten: Ausgehend von den Bauteilen einer Elektronikeinheit, werden diese in Gruppen zusammengefasst. Beispiele für Gruppenbildungen sind: Gruppierungen von Bauteilen, welche zusammen jeweils einer gemeinsamen Funktion innerhalb der Elektronikeinheit dienen; Gruppierung von Bauteilen, welche aufgrund ihrer Eigenschaften oder aufgrund der Umgebungs- oder Prozessbedingungen eine Ausfallwahrscheinlichkeit aufweisen, welche innerhalb der Betriebszeit der Elektronikeinheit liegt; Gruppierung von Bauteilen, wobei eine möglichst große Anzahl an Bauteilen derartig zusammengefasst wird, dass eine Veränderung eines jeden Bauteils sich auf das Antwortsignal auswirkt. Jede Gruppe wird für den Test mit einem Abfragesignal beaufschlagt und ein Antwortsignal wird gemessen. Dabei handelt es sich beispielsweise um den Spannungsabfall über die jeweiligen Gruppen. Die Spannungsmessung oder die Messung des Antwortsignals bzw. die Beaufschlagung mit dem Abfragesignal erfolgt dabei vorzugsweise mit Bauteilen, die frei von der eigentlichen Funktion der Elektronikeinheit sind, die also in dem Fall, dass die Elektronikeinheit ein Bestandteil eines Messgerätes ist, nicht für die Messung an sich verwendet werden. Das gemessene Antwortsignal bzw. der Spannungsabfall wird dann entsprechend z.B. mit einem Mikroprozessor ausgewertet.

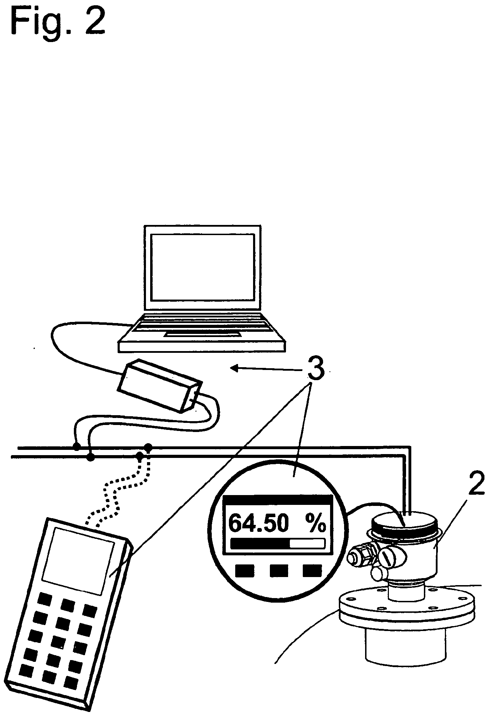

In der Fig. 2 ist dargestellt, in welchen Systemumgebungen das erfindungsgemäße Verfahren umgesetzt werden kann bzw. welche Steuereinheiten 3 mit dem erfindungsgemäßen Messgerät kommunizieren können. Das Messgerät ist hier angedeutet, an einem Behälter befestigt und die Elektronikeinheit 2 befindet sich außerhalb des Prozesses. Die Elektronikeinheit 2 ist direkt mit einem Anzeige- und Bedienmodul oder über einen Datenbus, z.B. HART, Fieldbus-Foundation mit einem für den Feldbus entsprechendes Bediengerät bzw. über eine Kommunikationseinheit mit einem Laptop als Teil einer Steueranlage verbunden. Über diese Beispiele von Steuereinheiten 3 wird der Test über die einzelnen Gruppen durchgeführt und werden beispielsweise entsprechend die Wartungsintervalle festgesetzt. Es gibt also die Möglichkeiten, dass die Steuereinheit 3 ein Teil des Messgerätes ist und vor Ort die Tests durchführt oder es gibt eine übergeordnete Einheit, welche für den Testfall zugeschaltet wird, welche beispielsweise direkt auf das Messgerät einwirkt oder welche passende Software in das Gerät lädt, damit dort der Test durchgeführt werden kann.

### Bezugszeichenliste

**Tabelle 1**

| | |
|---|---|
| 1 | Sensorelement |
| 2 | Elektronikeinheit |
| 3 | Steuereinheit |
| 4 | Analog-Digital-Wandler |
| 5 | Gruppe von Bauteilen |
| 6 | Mikroprozessor |
| 7 | Trennelement |

## Patentansprüche

1. Verfahren zum Testen einer Elektronikeinheit (2) einer Vorrichtung zur Bestimmung und/oder Überwachung einer Prozessgröße der Prozess- und Automatisierungstechnik,
wobei die Elektronikeinheit (2) eine Vielzahl von elektrischen Bauteilen aufweist,
**dadurch gekennzeichnet,**
**dass** zumindest ein Teil der elektrischen Bauteile in mindestens eine Gruppe (5) zusammengefasst wird,
**dass** die Gruppe (5) mit einem Abfragesignal beaufschlagt wird,
**dass** ein Antwortsignal der Gruppe (5) empfangen wird,
und
**dass** das Antwortsignal ausgewertet wird, wobei das Antwortsignal mit einem Sollwert verglichen wird und aus dem Vergleich des Antwortsignals mit dem Sollwert eine Voraussage auf das zukünftige Verhalten der Bauteile der Gruppe (5), von welcher das Antwortsignal empfangen wurde, getätigt wird,
und wobei das Testen der Gruppe (5) zeitgleich mit den eigentlichen Aufgaben der Elektronikeinheit oder in besonderen Testphasen erfolgt.

2. Verfahren nach Anspruch 1,
**dadurch gekennzeichnet,**
**dass** aus dem Vergleich des Antwortsignals mit dem Sollwert eine Voraussage über die zu erwartende Lebenszeit der Bauteile der Gruppe (5), von welcher das Antwortsignal empfangen wurde, ermittelt wird.

3. Verfahren nach mindestens einem der Ansprüche 1 bis 2,
**dadurch gekennzeichnet,**
**dass** der Spannungsabfall über die Gruppe (5) gemessen wird,
und
**dass** der gemessene Spannungsabfall ausgewertet wird.

4. Verfahren nach mindestens einem der Ansprüche 1 bis 3,
**dadurch gekennzeichnet,**
**dass** die Gruppe gemäß der Ausfallrate der Bauteile gebildet wird.

5. Verfahren nach mindestens einem der Ansprüche 1 bis 3,
**dadurch gekennzeichnet,**
**dass** die Gruppe gemäß der Funktion der Bauteile in der Elektronikeinheit gebildet wird.

6. Verfahren nach mindestens einem der Ansprüche 1 bis 5,
**dadurch gekennzeichnet,**
**dass** mindestens die Messung des Spannungsabfalls mit mindestens einem Analog-Digital-Wandler erfolgt, welcher in Bezug auf die Funktion der Elektronikeinheit ungenutzt ist.

7. Verfahren nach mindestens einem der Ansprüche 1 bis 6,
**dadurch gekennzeichnet,**
**dass** die Gruppe (5) derartig modifiziert und/oder erweitert wird, dass eine Änderung mindestens eines Bauteiles der Gruppe (5) zu einer Änderung des von der Gruppe (5) empfangbaren Antwortsignals führt.

8. Vorrichtung eingerichtet
zur Bestimmung und/oder Überwachung mindestens einer
Prozessgröße der Prozess- und Automatisierungstechnik,
mit mindestens einem Sensorelement, (1),
und
mit mindestens einer Elektronikeinheit (2),
wobei die Elektronikeinheit (2) eine Vielzahl von elektrischen Bauteilen beinhaltet,
**dadurch gekennzeichnet,**
**dass** mindestens eine Steuereinheit (3) vorgesehen ist, welche derartig ausgestaltet ist, dass die Steuereinheit (3) mindestens eine Gruppe (5) mindestens eines Teiles der Bauteile mit einem Abfragesignal beaufschlagt, wobei das Testen der Gruppe (5) zeitgleich mit den eigentlichen Aufgaben der Elektronikeinheit oder in besonderen Testphasen erfolgt, so dass die Steuereinheit (3) von der Gruppe (5) ein Antwortsignal empfängt, und dass die Steuereinheit (3) das Antwortsignal in Hinsicht auf Veränderungen der Bauteile der Gruppe auswertet, wobei das Antwortsignal mit einem Sollwert verglichen wird und aus dem Vergleich des Antwortsignals mit dem Sollwert eine Voraussage auf das zukünftige Verhalten der Bauteile der Gruppe (5), von welcher das Antwortsignal empfangen wurde, getätigt wird, und wobei die Vorrichtung so ausgestaltet ist, dass das Testen der Gruppe (5) zeitgleich mit den eigentlichen Aufgaben der Elektronikeinheit oder in besonderen Testphasen erfolgt.

9. Vorrichtung nach Anspruch 8,
**dadurch gekennzeichnet,**
**dass** mindestens ein Analog-Digital-Wandler (4) vorgesehen ist, welcher frei von den Messaufgaben ist und über welchen die Steuereinheit (3) das Antwortsignal aufnimmt.

## Claims

1. Procedure to test an electronics unit (2) of an apparatus designed to determine and/or monitor a process variable in process and automation engineering, wherein the electronics unit (2) has a large number of electrical components,
**characterized in that**
at least some of the electrical components are grouped into at least one group (5),
**in that** an interrogation signal is fed to the group (5),
**in that** a response signal is received from the group (5),
and
**in that** the response signal is analyzed, wherein the response signal is compared against a target value and the comparison of the response signal with the target value is the basis for forecasting the future behavior of the components of the group (5) from which the response signal was received,
and wherein the group (5) test is performed simultaneously with the actual tasks of the electronics unit or in particular test phases.

2. Procedure as claimed in Claim 1,
**characterized in that**
on the basis of the comparison of the response signal with the target value a forecast is made on the expected lifetime of the components of the group (5) from which the response signal was received.

3. Procedure as claimed in at least one of the Claims 1 to 2,
**characterized in that**
the drop in voltage over the group (5) is measured,
and
that the measured drop in voltage is evaluated.

4. Procedure as claimed in at least one of the Claims 1 to 3,
**characterized in that**
the group is formed according to the failure rate of the components.

5. Procedure as claimed in at least one of the Claims 1 to 3,
**characterized in that**
the group is formed according to the function of the components in the electronics unit.

6. Procedure as claimed in at least one of the Claims 1 to 5,
**characterized in that**
the voltage drop is at least measured with at least one analog-to-digital converter which is not utilized with regard to the function of the electronics unit.

7. Procedure as claimed in at least one of the Claims 1 to 6,
**characterized in that**
the group (5) is modified and/or extended in such a way that a change to at least one component in the group (5) results in a change in the response signal that can be received from the group (5).

8. Apparatus set up for determining and/or monitoring at least one process variable in process and automation engineering,
with at least one sensor element (1),
and
with at least one electronics unit (2),
wherein the electronics unit (2) has a large number of electrical components,
**characterized in that**
at least one control unit (3) is provided, which is designed in such a way that the control unit (3) feeds an interrogation signal to at least one group (5) of at least one part of the components, wherein the group (5) test is performed simultaneously with the actual tasks of the electronics unit or in particular test phases such that the control unit (3) receives a response signal from the group (5) and such that the control unit (3) evaluates the response signal with regard to changes among the components of the group, wherein the response signal is compared against a target value and on the basis of the comparison of the response signal with the target value the future behavior of the components of the group (5) from which the response signal was received is forecast, and wherein the apparatus is designed in such a way that the group (5) test is performed simultaneously with the actual tasks of the electronics unit or in particular test phases.

9. Apparatus as claimed in Claim 8,
**characterized in that**
at least one analog-to-digital converter (4) is provided, which is free from the measuring tasks and via which the control unit (3) takes up the response signal.

## Revendications

1. Procédé destiné au test d'une unité électronique (2) d'un dispositif destiné à la détermination et/ou la surveillance d'une grandeur process de la technique d'automatisation des process,
pour lequel l'unité électronique (2) comporte un grand nombre de composants électriques,
**caractérisé**
**en ce qu'**une partie des composants électriques sont regroupés en au moins un groupe (5),
**en ce que** le groupe (5) est alimenté par un signal d'interrogation,
**en ce qu'**un signal de réponse est reçu du groupe (5),
et
**en ce que** le signal de réponse est évalué, le signal de réponse étant comparé avec une valeur de consigne et une prévision étant réalisée concernant le comportement futur des composants du groupe (5), à partir duquel le signal de réponse a été reçu,
et pour lequel le test du groupe (5) est effectué simultanément avec les tâches effectives de l'unité électronique ou dans des phases de test particulières.

2. Procédé selon la revendication 1,
**caractérisé**
**en ce qu'**est déterminé, à partir de la comparaison du signal de réponse avec la valeur de consigne, une prévision sur la durée de vie escomptée des composants du groupe (5), qui a reçu le signal de réponse.

3. Procédé selon au moins l'une des revendications 1 à 2,
**caractérisé**
**en ce qu'**est mesurée la chute de tension à travers le groupe (5),
et
**en ce que** la chute de tension mesurée est évaluée.

4. Procédé selon au moins l'une des revendications 1 à 3,
**caractérisé**
**en ce que** le groupe est formé en fonction du taux de défaillance des composants.

5. Procédé selon au moins l'une des revendications 1 à 3,
**caractérisé**
**en ce que** le groupe est formé selon la fonction des composants au sein de l'unité électronique.

6. Procédé selon au moins l'une des revendications 1 à 5,
**caractérisé**
**en ce qu'**intervient au moins la mesure de la chute de tension avec au moins un convertisseur analogique-numérique, lequel est inutilisé par rapport à la fonction de l'unité électronique.

7. Procédé selon au moins l'une des revendications 1 à 6,
**caractérisé**
**en ce que** le groupe (5) est modifié et/ou étendu de telle sorte qu'une modification d'au moins un composant du groupe (5) conduit à une modification du signal de réponse pouvant être reçu par le groupe (5).

8. Dispositif destiné à la détermination et/ou la surveillance d'au moins une grandeur process de la technique d'automatisation des process,
avec au moins un élément capteur (1),
et
avec au moins une unité électronique (2),
l'unité électronique (2) contenant un grand nombre de composants électroniques,
**caractérisé**
**en ce qu'**est prévue au moins une unité de commande (3), laquelle est conçue de telle sorte que l'unité de commande (3) alimente au moins un groupe (5) d'au moins une partie des composants avec un signal d'interrogation, le test du groupe (5) s'effectuant simultanément avec les tâches effectives de l'unité électronique ou dans des phases de test particulières, de sorte que l'unité de commande (3) reçoit du groupe (5) un signal de réponse, et en ce que l'unité de commande (3) évalue le signal de réponse par rapport aux modifications des composants du groupe, le signal de réponse étant comparé avec une valeur de consigne et une prévision concernant le comportement futur des composants du groupe, à partir duquel le signal de réponse a été reçu, étant effectuée à partir de la comparaison du signal de réponse avec la valeur de consigne, et le dispositif étant conçu de telle sorte que le test du groupe (5) s'effectue simultanément avec les tâches effectives de l'unité électronique ou dans des phases de test particulières.

9. Dispositif selon la revendication 8,
**caractérisé**
**en ce qu'**est prévu au moins un convertisseur analogique-numérique (4), lequel est libéré des tâches de mesure et par l'intermédiaire duquel l'unité de commande (3) prend en charge le signal de réponse.
